# EUROPEAN PATENT SPECIFICATION

(11) **EP 1 709 135 B1**
(45) Date of publication and mention of the grant of the patent: **10.03.2010**
(21) Application number: 05702226.1
(22) Date of filing: 13.01.2005
(51) Int. Cl.: C09K 3/14

(54) **COATED ABRASIVES**
BESCHICHTETE SCHLEIFMITTEL
ABRASIFS REVETUS

(30) Priority: 15.01.2004 IE 20040024
(43) Date of publication of application: 11.10.2006
(73) Proprietor: Element Six Limited, County Clare (IE)
(72) Inventor: EGAN, David Patrick, County Clare (IE); ENGELS, Johannes Alexander, County Tipperary (IE); FISH, Michael Lester, County Clare (IE)
(74) Representative: Price, Nigel John King
(86) International application number: PCT/IB2005/000056
(87) International publication number: WO 2005/078041

(56) References cited:
- EP-A- 0 467 404
- US-A- 4 399 167
- US-A- 5 024 680
- US-A- 5 224 969
- US-A- 5 346 719

## Description

### BACKGROUND OF THE INVENTION

This invention relates to coated abrasives, a process for their production, and to coated abrasives for use in abrasive-containing tools.

Abrasive particles such as diamond and cubic boron nitride are commonly used in cutting, grinding, drilling, sawing and polishing applications. In such applications, abrasive particles are mixed with metal powder mixes, then sintered at high temperatures to form bonded cutting elements. Typical bond matrices contain iron, cobalt, copper, nickel and/or alloys thereof.

Common problems in applications are retention of particles in the bond matrix, and resistance against oxidative attack during the sintering process and the subsequent application.

These problems are commonly addressed by coating the abrasive particles with metals or alloys which bond chemically to the particle, and alloy to the bond matrix. Typically, chemical vapour deposition (CVD) or physical vapour deposition (PVD sputter coating) techniques are used. Titanium carbide is an example of a material that has been proposed as a coating for abrasive particles, because of its good adhesion to diamond. Chromium carbide is a similar coating material that can be used.

A problem with the use of titanium carbide coatings where the bond matrix contains bronze or Cu is that these materials tend to react with the titanium carbide, such that it may be reacted away reducing or neutralizing any possible enhanced particle retention. In cases involving high temperatures or times, the diamond particles are then susceptible to graphitisation of the diamond particle surfaces, where the bond matrix also contains metals that are typically used as solvent/catalysts for diamond synthesis. Examples of such metals are Fe, Co and Ni. In the molten state, these metals are capable of dissolving diamond, which precipitates on cooling to form graphite. This process of graphitisation of the diamond surface not only weakens the particles but may also result in poorer retention of the particles in the bond.

Further, in order for the coating to protect the diamond particles, it has to form a barrier between the bond matrix and the particles. In other words, it should be impermeable and dense, so that components of the bond matrix are unable to pass through and make contact with the particle surface. One way the components could pass through the coating is by solid-state diffusion through the coating. Alternatively, if the coating is incomplete, cracked or porous, components may pass through the coating to reach the particle surface. A coating may initially be dense and impermeable, but during the sintering process, a phase change may occur due to alloying with the bond matrix, for example, which results in the formation of a less dense alloy, or perhaps a porous coating, which allows passage of the bond matrix components through the coating to the particle surface.

United States Patent No. 5,024,680 describes a multiple coated diamond grit for improved retention in a tool matrix. The coated grit comprises a first coating layer of a metal carbide of a strong carbide former, preferably chromium, chemically bonded to the diamond, and a second metal coating of an oxidation resistant carbide former, preferably tungsten, tantalum, or molybdenum chemically bonded to the first metal layer. A third metal layer coating of an alloying metal such as nickel may be added. The coated grit is produced by applying a first layer of metal to the grit by metal vapour deposition, followed by applying the second layer metal by chemical vapour deposition.

It is well known that elements like Fe, Co and Ni can graphitise diamond. Where chromium carbide is used as a coating material, it is not particularly effective at preventing such graphitisation, e.g. in the case of iron, which limits its effectiveness.

The second layer is also specifically a thick layer. It is therefore necessary to have the second layer chemically bonded to the first layer, requiring the use of either high temperature coating processes or a separate heating step to create such chemical bonding.

### SUMMARY OF THE INVENTION

A coated super-hard abrasive comprising a core of super-hard abrasive material, an inner layer of a metal carbide, nitride or carbonitride chemically bonded to an outer surface of the super-hard abrasive material and an outer layer of tungsten physically deposited on the inner layer.

The outer layer is preferably applied by physical vapour deposition.

The super-hard abrasive material may be diamond or cBN based.

The inner layer is preferably a titanium carbide coating in the case of a diamond abrasive core, or a titanium nitride or boride coating in the case of a cBN abrasive core.

As the outer tungsten coating is applied by physical vapour deposition, no portion thereof, in particular the inner portion thereof, is carbided. It thus forms an excellent barrier for protecting the inner layer and substrate.

The thickness of the outer layer is typically from about 0.05 µm to about 10 µm, in particular about 0.2 µm to about 1 µm.

### DESCRIPTION OF PREFERRED EMBODIMENTS

Ti in the form of titanium or titanium carbide or titanium or titanium nitrides, borides or boronitrides have been shown to be useful coating materials for diamond and cBN substrates, respectively. They are particularly useful because of their ability to bind chemically to the substrate, to protect the substrate, and to improve the bonding between the substrate and bonding agents such as bronzes or matrix elements. However, as has been mentioned previously, they are not suitable in some applications, particularly where they are sintered in aggressive sintering conditions in the presence of bronze or copper, and where the bond matrix contains high amounts of ferrous metals, for example.

It has been found that the advantages of titanium based coatings can be extended to other applications where an outer coating of tungsten is applied over the titanium based coating layer. This is particularly the case where diamond grit is used in a metal bond matrix containing ferrous metals to form an abrasive tool component upon sintering. It is also useful where the titanium carbide coating, in the case of diamond particles, would be reacted away by a constituent of the matrix material, for example bronze, during sintering of coated diamond-containing abrasive segments; where the titanium based coating would be reacted away by liquid infiltrants used to form a coated diamond-containing infiltrated powder metal component, such as a drill crown for mining exploration drilling; or where the titanium based coating would be reacted away by brazes used to fix a superabrasive component to another metallic or ceramic material.

The outer tungsten layer does not have a carbided inner portion, which is not necessary as the purpose of the outer layer is primarily as a barrier for protecting the inner layer and substrate and sufficient interlayer bonding can be achieved by keeping the outer coating thin. The outer coating has a thickness of about 0.05 µm to about 10 µm, in particular about 0.2 µm to about 1 µm.

It is especially useful in the making of diamond impregnated tools such as segments for saw blades, drills, beads for diamond wires especially where high amounts of bronze or copper limit the usefulness of titanium carbide coatings, the making of brazed diamond layer tools such as brazed diamond wire beads, the making of diamond containing metal matrix composites, brazing of diamond materials such as affixing TSPCD, PCD and diamond drillstones to a drill body, affixing CVD, monocrystal, TSPCD and PCD to a saw blade, tool post, drill body and the like.

Additionally, the coated diamond impregnated tools yield improved performance such as longer tool life and higher productivity. Coated diamond particles of the invention for brazing applications allow the use of simple brazes that work in air as opposed to active brazes containing Ti which require the exclusion of oxygen.

The coated abrasive particles are preferably formed using a hot coating process for applying the inner layer and a PVD or low temperature CVD process for applying the outer layer.

The diamond grit particles are those used conventionally in the manufacturing of metal bonded tools. They are generally uniformly sized, typically 0.1 to 10 mm. Examples of such diamond grit particles include: Micron grit 0.1 to 60 micron, wheel grit 40 micron to 200 micron, saw grit 180 micron to 2 millimeter, mono crystal 1 millimeter to 10 millimeter, CVD inserts of a few square millimeter to discs up to 200 millimeter diameter, PCD inserts of a few square millimeter to discs 104 millimeter diameter, cBN grit in micron range 0.1 to 60 micron, in wheel grit range 40 micron to 200 micron, PCBN inserts of a few mm to discs up to 104 mm diameter.

The diamond particles are first coated in a hot coating process to provide an inner layer, which may be a metal layer or a metal carbide, nitride or carbonitride layer. In the case of cBN, such inner coating would typically be a metal nitride or boride or boronitride layer. In this hot coating process, the metal-based coat is applied to the diamond substrate under suitable hot conditions for such bonding to take place. Typical hot coating technologies that can be used include processes involving deposition from a metal halide gas phase, CVD processes or thermodiffusion vacuum coating or metal vapour deposition processes, for example. Deposition from a metal halide gas phase and CVD processes are preferred.

In processes involving deposition from a metal halide gas phase, the particles to be coated are exposed to a metal-halide containing the metal to be coated (e.g. Ti) in an appropriate gaseous environment (e.g. non-oxidising environments containing one or more of the following: inert gas, hydrogen, hydrocarbon, reduced pressure). The metal halide may be generated from a metal as part of the process.

The mixture is subjected to a heat cycle during which the metal-halide transports the Ti to the surfaces of the particles where it is released and is chemically bonded to the particles.

The outer layer of tungsten is deposited using a cold coating technique such as low temperature CVD processes or PVD, which is preferred. It is a low temperature process in that insufficient heat is generated to cause significant carbide formation. Hence, if used alone, it would result in relatively poor adhesion to the diamond particles. An example of a PVD process for applying the outer coating is sputter coating. In this method, a flux of tungsten metal vapour is produced by an excitation source such as a magnetron. Articles such as superabrasive grit or a component placed in the flux become coated with tungsten metal.

Examples of coated abrasives of the invention include:
i) Diamond saw grit coated with titanium carbide and tungsten (halide gas titanium carbide coating, followed by physical deposition (PVD) of tungsten). Used for producing abrasive segments for saws or drills, especially with high bronze matrices or when an infiltration manufacturing process is used.
ii) Diamond wheel grit or micron grit coated with titanium carbide and tungsten (halide gas titanium carbide coating followed by physical deposition of tungsten). Used for producing grinding wheels, especially when bronze bonds are used.
iii) cBN wheel grit or micron grit coated with titanium nitride or boride (whether singly or in combination) and tungsten (halide gas titanium based coating, followed by physical deposition of tungsten). Used for producing grinding wheels, especially when bronze bonds are used.
iv) Titanium carbide plus tungsten coated PCD. Used as a cutting tool insert for brazing into a tungsten carbide blank.
v) Titanium nitride or boride (whether singly or in combination) plus tungsten coated PCBN. Used as a cutting tool insert for brazing into a tungsten carbide blank.
vi) Titanium carbide plus tungsten coated CVD or monocrystal. Used as a cutting tool insert for brazing into a tungsten carbide blank, or as dresser logs for sintering or brazing into dresser posts.

The invention will now be described, by way of example only, with reference to the following non-limiting example.

### EXAMPLE

Diamond grit from Element Six, 40/45 US mesh size, was coated in a CVD process to produce TiC coated diamond according to general methods commonly known in the art. The CVD TiC coated diamond was then used as the substrate for the second coating step. 10,000 carats of this TiC coated diamond, 40145 US mesh size, was placed in a magnetron sputter coater with a rotating barrel and a pure tungsten metal plate as the target. The coating chamber was evacuated, argon was admitted and the power turned on to form plasma. Sputtering power was increased to 5000W while rotating the barrel to ensure an even coating on all the diamond particles. After sputtering for 7.5 hours, the coated diamond was allowed to cool for 10 hours before removing from the chamber.

An analysis of this coated diamond was undertaken, consisting of X-ray diffraction, X-ray fluorescence, Chemical assay of the coating, Optical and Scanning Electron Microscopy image analysis, and particle fracture followed by cross-sectional analysis on the SEM.

Visually, this coating appeared a slightly dull, metallic silver / grey colour. This colouring appeared evenly distributed over each particle and each particle appeared identical. The coating looked uniform and without any uncoated areas. Observation on the SEM again showed an even coating with a very smooth morphology. Particles were fractured and the coatings cross-section observed on the SEM. Two distinct coatings were visible. The tungsten part of this coating was measured to have a thickness of about 0.45 microns. This particular coating resulted in an assay of 5.9%. The TiC coating in this size used for this batch typically has an assay of 0.77%. The rest of the 5.9% is therefore attributable to the tungsten layer on top of the TiC inner layer. When analysed using XRD, diamond, TiC and W were found. XRF analysis showed 87% W and 13% Ti.

## Claims

1. A coated super-hard abrasive comprising a core of super-hard abrasive material, an inner layer of a metal carbide, nitride or carbonitride chemically bonded to an outer surface of the super-hard abrasive material and an outer layer of tungsten physically deposited on the inner layer, wherein no portion of the tungsten coating is carbided.

2. A coated super-hard abrasive according to claim 1, wherein the outer layer is deposited by physical vapour deposition.

3. A coated super-hard abrasive according to claim 1 or claim 2, wherein the super-hard abrasive material is diamond or cBN based.

4. A coated super-hard abrasive according to claim 3, wherein the Inner layer is a titanium carbide coating in the case of a diamond based core, or a titanium nitride or boride coating in the case of a cBN based core.

5. A coated super-hard abrasive according to any one of the preceding claims, wherein the thickness of the outer layer is from about 0.05 µm to about 10 µm.

6. A coated super-hard abrasive according to any one of the preceding claims, wherein the thickness of the outer layer is from about 0.2 µm to about 1 µm.

## Patentansprüche

1. Beschichtetes superhartes Schleifmittel, das einen Kern aus superhartem Schleifmaterial, eine Innenschicht aus Metallkarbid, Metallnitrid oder Carbonitrid, die chemisch an eine Außenfläche des superharten Schleifmaterials gebunden ist, und eine Außenschicht aus Wolfram umfasst, die physikalisch auf der Innenschicht angelagert ist, wobei kein Abschnitt der Wolframbeschichtung carbidisiert ist.

2. Beschichtetes superhartes Schleifmittel nach Anspruch 1, wobei die Außenschicht durch physikalische Gasphasenabscheidung angelagert ist.

3. Beschichtetes superhartes Schleifmittel nach Anspruch 1 oder 2, wobei das superharte Schleifmaterial auf Diamant oder CBN basiert.

4. Beschichtetes superhartes Schleifmittel nach Anspruch 3, wobei die Innenschicht im Fall eines auf Diamant basierenden Kerns eine Titankarbidbeschichtung ist oder im Fall eines auf CBN basierenden Kerns eine Titannitrid- oder -boridbeschichtung ist.

5. Beschichtetes superhartes Schleifmittel nach einem der vorhergehenden Ansprüche, wobei die Dicke der Außenschicht zwischen etwa 0,05 µm und etwa 10 µm liegt.

6. Beschichtetes superhartes Schleifmittel nach einem der vorhergehenden Ansprüche, wobei die Dicke der Außenschicht zwischen etwa 0,2 µm und etwa 1 µm liegt.

## Revendications

1. Abrasif super-dur revêtu, comprenant un coeur de matériau abrasif super-dur, une couche interne d'un carbure, nitrure ou carbonitrure de métal chimiquement lié à une surface externe du matériau abrasif super-dur et une couche externe de tungstène physiquement déposée sur la couche interne, dans lequel aucune partie du revêtement de tungstène n'est carburée.

2. Abrasif super-dur revêtu selon la revendication 1, dans lequel la couche externe est déposée par dépôt physique en phase vapeur.

3. Abrasif super-dur revêtu selon la revendication 1 ou la revendication 2, dans lequel le matériau abrasif super-dur est à base de diamant ou de cBN.

4. Abrasif super-dur revêtu selon la revendication 3, dans lequel la couche interne est un revêtement de carbure de titane dans le cas d' un coeur à base de diamant, ou un revêtement de nitrure ou borure de titane dans le cas d'un coeur à base de cBN.

5. Abrasif super-dur revêtu selon l'une quelconque des revendications précédentes, dans lequel l'épaisseur de la couche externe est d'environ 0,05 µm à environ 10 µm.

6. Abrasif super-dur revêtu selon l'une quelconque des revendications précédentes, dans lequel l'épaisseur de la couche externe est d'environ 0,2 µm à environ 1 µm.
